# EUROPEAN PATENT SPECIFICATION

(11) **EP 0 516 185 B1**
(45) Date of publication and mention of the grant of the patent: **03.09.1997**
(21) Application number: 92112517.5
(22) Date of filing: 08.04.1988
(51) Int. Cl.: H01L 25/065, H01L 23/32, G06F 12/06, G06F 11/20, H01L 27/02

(54) **Wafer-scale semiconductor integrated circuit device**
Integrierte Halbleiterschaltungen Vorrichtung von Scheibengrösse
Dispositif semi-conducteur à circuits intégrés à l'échelle d'une pastille

(30) Priority: 22.04.1987 JP 97331/87; 22.04.1987 JP 97329/87; 22.04.1987 JP 97330/87; 22.04.1987 JP 97326/87; 24.04.1987 JP 99779/87
(43) Date of publication of application: 02.12.1992
(62) Divisional of application: 88303160.1
(73) Proprietor: HITACHI, LTD., Chiyoda-ku, Tokyo 100 (JP)
(72) Inventor: Tazunoki, Masanori, Hamura-shi, Tokyo (JP); Mishimagi, Hiromitsu, 3-chome, Akishima-shi, Tokyo (JP); Homma, Makoto, Nishitama-gun, Tokyo (JP); Sakuta, Toshiyuki, Ohme-shi, Tokyo (JP); Nakamura, Hisashi, Ohme-shi, Tokyo (JP); Sasaki, Keiji, Musashino-shi, Tokyo (JP); Enomoto, Minoru, Tokorozawa-shi, Saitama (JP); Satoh, Toshihiko, Sayama-shi, Saitama (JP); Sahara, Kuniso, Iruma-shi, Saitama (JP); Kuroda, Shigeo, Ohme-shi, Tokyo (JP); Otsuka, Kanji, Higashiyamato-shi, Tokyo (JP); Kawamura, Masao, Fuchu-shi, Tokyo (JP); Kurosawa, Hinoko, Hino-shi, Tokyo (JP); Ito, Kazuya, Hamura-shi, Tokyo (JP)
(74) Representative: Calderbank, Thomas Roger

(56) References cited:
- HEWLETT-PACKARD JOURNAL, vol. 34, no. 8, August 1983, Palo Alto US, pp. 14-20; C.G. LOB et al.: "High-Performance VLSI Memory System"
- PATENT ABSTRACTS OF JAPAN vol. 11, no. 271 (E-536)(2718) 3 September 1987 ; & JP-A-62 72 156
- PATENT ABSTRACTS OF JAPAN vol. 5, no. 70 (E-56)(742) 12 May 1981 ; & JP-A-56 18 439

## Description

The present invention relates to a semiconductor memory device formed on a large-sized semiconductor substrate such as a semiconductor wafer.

In general, semiconductor integrated circuits are constructed on respective parts of a substate, i.e. a semiconductor wafer chip the wafer then being subdivided by dicing it into a plurality of parts each corresponding to one or more integrated circuits. However, recently constructions have been investigated in which the semiconductor wafer is not subdivided, but a plurality of integrated circuits are- fabricated on the whole of the semiconductor wafer so as to construct a large-sized semiconductor integrated circuit. Such a semiconductor manufacturing technique is described in e.g. Japanese patent KOKAI (Disclosure) 61-290739, in which one large-sized semiconductor integrated circuit is constructed on the entire semiconductor wafer.

A semiconductor memory device fabricated by a wafer sized very LSI has been proposed from, for instance Japanese patent KOKAI (Disclosure) application no: 59-201441. In the wafer-sized semiconductor memory device described as in the above disclosure, the cutting of the defective chips and removal of these defective chips are performed by such a way that fuses, or power source lines are cut out by irradiating focused ion beams or laser light rays, and only those chips without defects are connected by the final wiring. However, a large number of manufacturing stages and thus, a large number of masks are required. As a result, the throughput is not improved and the cost is high. Moreover, one or more redundant blocks for removing the defects is built in the memory system body within the wafer so that to increase the redundancy, the total area which the entire system body occupies must be reduced. If a faulty block is to be discovered by means of probing, the lower throughput must be accepted. In some cases, such a probing check may cause another defect.

EP-A-0153015 discloses a wafer-scale semiconductor integrated circuit in which a plurality of memory blocks are arranged on the main surface of the wafer-scale substrate of the integrated circuit. The memory blocks are of substantially the same area.

A wafer-scale semiconductor integrated circuit device according to claim 1 and comprising:
a wafer-scale semiconductor substrate having a main surface including a central portion, wherein the main surface of the wafer-scale semiconductor substrate has substantially a circular shape;
a plurality of memory blocks being formed on the main surface of the wafer-scale semiconductor substrate and each having a substantially the same area, wherein the memory blocks are provided at the central portion of the main surface;
a plurality of preliminary memory circuits formed at the peripheral portion of the main surface of the wafer-scale semiconductor substrate so as to surround the plurality of memory blocks wherein each preliminary memory circuit occupies a smaller area than that of the memory block; and
a control circuit arranged to detect when a defect is present in at least a part of any one of said memory blocks, to select one or more of the preliminary memory blocks, the memory capacity of the selected preliminary memory block(s) being the same as said at least a part of said any one of said memory blocks, to inhibit the storing of data in said at least a part of said any one of said memory blocks, and to store said data in the selected preliminary memory block(s) rather than said at least a part of said any one of said memory blocks, thereby to relieve said defect.
The wafer-scale integrated circuit device may be constructed of a plurality of memory mats, a memory array section of the semiconductor memory circuit being subdivided. Then, a preliminary memory circuit having a decoder circuit corresponding to the memory mat is arranged around a peripheral section of a wafer, and when a defect is present, the selection of the preliminary memory circuit is performed, and the selection of the memory circuit is prohibited.

An embodiment of the present invention will now be described in detail by way of example, with reference to the accompanying drawings, in which:

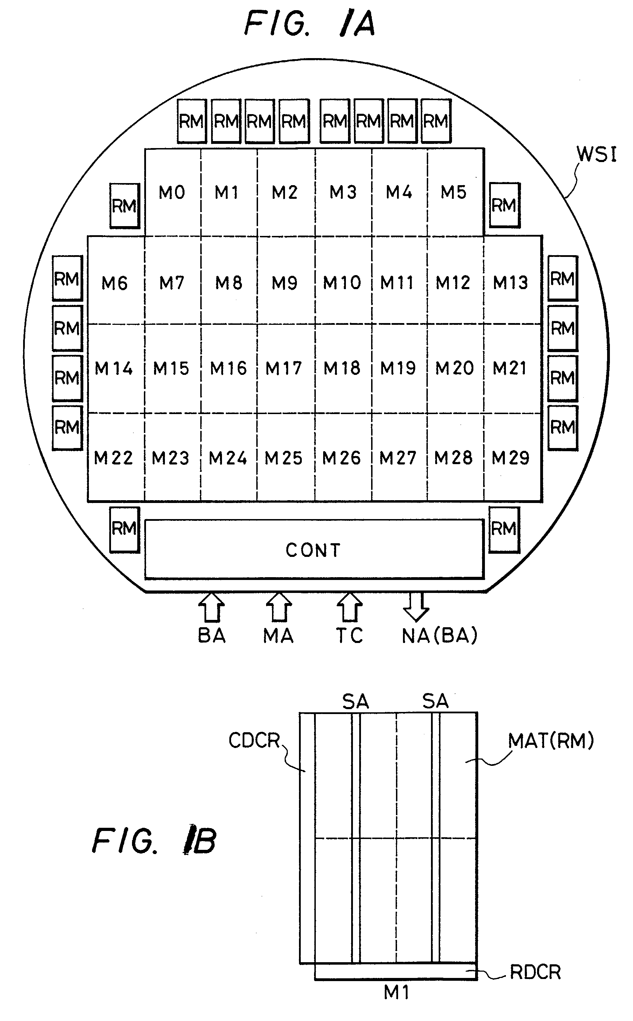

Fig. 1A is a schematic block diagram of a memory system, according to an embodiment, to which the present invention is applied;
Fig. 1B is a schematic block diagram of the memory block according to the embodiment;

In Fig. 1A, there is shown a block diagram of an embodiment in which the present invention is applied to a wafer-scale semiconductor memory device. Each of the circuit blocks shown in Fig. 1A is formed based upon the known manufacturing technique for a semiconductor integrated circuit. Each of the circuit blocks shown in Fig. 1A is drawn, taking account of the practical geometric circuit arrangement on a wafer-scale WSI (wafer-scale semiconductor integrated circuit device).

The memory blocks MO to M29 are not specifically limited, but are constructed of memory arrays constituting dynamic type RAM's, and also decoder circuits for performing their selecting operation. That is to say, as shown in Fig. 1B, the memory block Mi is, briefly speaking, constructed of a memory array, a column decoder CDCR for selecting its data line (bit line, or digit line), and a row decoder RDCR for selecting its word line. As represented by a dotted line in Fig. 1B, the memory array is subdivided into two memory mats, in principle. A sense amplifier SA is arranged on each center portion of the respective memory mats. Since such a shared sense amplifier system is employed where the sense amplifier SA is arranged on the center portion of the memory mats, a switch circuit may be employed for selectively connecting this sense amplifier to either memory mat (not shown in detail). Although not shown in the figures, a column switch circuit may be provided in parallel to this sense amplifier. It should be noted that the above-described memory block Mi includes various circuits (not shown in detail). These arrangements of the memory array and the address selecting circuit may be constructed of the circuit equivalent to the known dynamic type RAM. In the embodiment, the memory array is also subdivided vertically to obtain two divided portions as illustrated in Fig. 1, for the sake of convenience.

The above-described memory blocks M0 to M29 require a relatively large rectangular area to be occupied. Accordingly, an empty space is produced around the peripheral portion of a substantially circular wafer WSI. To utilize this empty space, the above-described preliminary memory circuit RM is so designed as to occupy a relative smaller area where there are a memory array section corresponding to the memory mats subdivided from one memory block, and a decoder circuit thereof. As a result, a large quantity of the above-described preliminary memory circuits RM are formed at the peripheral portion of the wafer on which the memory block Mi required to have the relatively large occupied area can be formed. Such a circuit arrangement can prevent the practical memory capacity from being reduced when adding the redundant circuit. In other words, while adding the redundant functions, the memory system owning the larger memory capacity can be obtained.

Although the present invention is not restricted, a control circuit CONT may be arranged at a position corresponding to an orientation flat section of the wafer WSI. This control circuit CONT performs the selection operation of the above-described memory block Mi by receiving address signals BA and MA and a control signal TC supplied from the external source. To this end, an electrode to be connected to the above external terminal is provided on the above-described orientation flat section. This electrode is utilized for the probing when the memory system constituted by the above-described memory block circuit RM and also control circuit CONT formed on the wafer WSI is accomplished. The address signal BA among the above-described address signals corresponds to a block address signal for designating one memory blocks M0 to M29. The address signal MA corresponds to an address signal commonly supplied to the above-described respective memory blocks M0 to M29. Therefore, the control circuit CONT includes a decoder circuit for producing a selection signal for one memory block, while receiving the above-described block address signal BA. Between the above-described control circuit CONT and the respective memory blocks M0 to M29, there are arranged an address supply line for supplying the above-described common address signal MA, a signal line for supplying and receiving a read/write signal between the respective memory blocks M0 to M29, a timing signal for controlling various operations, and a selecting signal line formed by decoding the above-described block address signal BA. Due to complex circuitry, such signal lines are omitted in the figures. Furthermore, there are employed an address supply line for supplying an address signal with respect to the above-described preliminary memory circuit RM, a signal line for receiving/supplying a read/write signal between the respective preliminary memory circuits RM, and a signal line for the same timing signal and selection signal as in the above case, However, since the preliminary memory circuit RM has only 1/4 memory capacity, as compared with the memory capacity of one memory block Mi, the address setting operation and also the allocation of the selecting signal line can be performed by a program. The address signal except for the respective most significant bits of the row/column with respect to the above-described memory block Mi, is supplied to the respective decoder circuits. The selection signal line for the respective preliminary memory circuits RM is provided in one-to-one correspondence with the control circuit CONT. This selecting signal line is designated by combining the block address signal designated under control of the control circuit CONT with the remaining higher 2-bit address signal. As a consequence, one preliminary memory circuit RM is allocated to the address block and the higher 2-bit memory address by the address designation at the control circuit CONT.

As the invention is not limited to the following embodiment, the control circuit CONT performs the memory access with respect to the respective memory blocks M0 to M29 and owns such a function that while judging whether or not the defect is present, it sends out externally a failed address signal NA(block address) corresponding to the failed memory block.

The operation per se of the above-described memory system is similar to that of the conventional board-arranged memory device wherein the memory block is constructed of one semiconductor integrated circuit device, and the wafer WSI is substituted by a printed substrate.

In a memory system according to the embodiment, the block addresses are allocated to the respective memory blocks. As a consequence, when a defect is present in, for example, one memory block Mi,the memory block Mi essentially containing such a defect can be separated by invalidate the corresponding selection signal. It should be, however, noted that if a serious defect occurs such that a shortcircuit problem is present between the power supply line and the ground line of the circuit, the power supply line should be separated by projecting the laser ray, as similarly in the conventional system. Also in this case, since this defect can be discovered by the memory access from the control circuit CONT, and its failed address (block address) NA is externally derived, the above-described defect relieving can be relatively simply performed. Moreover, even if the defect occurs in one word line at the memory block and the data line connected to the memory cell, similarly the failed address NA is output, so that the program for relieving a defect can be made readily.

The above-described defect relieving operation by employing the above-described preliminary memory circuit RM, is performed every memory block according to the most simple way. That is to say, the selection is prohibited by cutting off, for instance, fuse means with respect to the memory block containing the defect. Then, the block address is stored in the memory circuit which utilizes the fuse means, when the memory address corresponding to the block address is detected, one memory block is constructed by four preliminary memory circuits RM, and thereafter this memory block is selected. Such a selection for the redundant circuit can be accomplished by utilizing the defect releiving technique which is performed at the word line or data line unit in the conventional dynamic type RAM.

When there is a defect in one memory mat among the above-described 1/4-divided memory mats of one memory block, the selection for the defective memory mat is detected while the remaining three memory mats remain alive, so that the selection is carried out for the above-described preliminary memory circuit. In this case, the defective, or failed address is designated in the control circuit CONT as the defective, or failed address based upon the block address and the respective 1-bit most significant bit of the row system and column system, in other words, the 2-bit address signal for designating one memory mat among the subdivided four memory mats MAT. When detecting the memory access with respect to this failed address, the supply of the selection signal for its memory block is prohibited, and the corresponding preliminary memory circuit RM is selected. In this case, since each of these preliminary memory circuits RM can be independently used, the redundancy can be increased.

The various advantages achieved in the embodiment will now be summarized.
(1). According to the embodiment, a plurality of circuit blocks each having a specific circuit function are employed, and the block address for designating the respective circuit blocks is allocated thereto, so that the system can be built up on the wafer. As a result, the independent function test for each of the circuit blocks can be done by designating the above-described block address, and the practical separation for the defective, or failed block can be performed by employing the above-described block address. Consequently, it is possible to omit the first conventional step where the connecting wire is cut out by irradiating the laser rays with respect to the failed block, and the wire is connected to the non-defective block.
(2). In a memory system where the circuit block having the specific circuit function is constituted by the memory array and the decoder circuit, this memory system is constructed of a plurality of mats and also the preliminary memory circuits corresponding to the subdivided mats. As a result, since the area occupied by the preliminary memory circuits can be made small, the preliminary memory circuits can be formed around the wafer peripheral portion where the above-described memory blocks cannot be formed. Consequently, as the entire surface of the wafer can be utilized, the memory capacity of the memory system can be essentially increased while adding the redundant function thereto.
(3). The area occupied by the above preliminary memory circuit can be made small, so that the practical redundancy can be increased since a failure occurrence rate in the preliminary memory circuit can be reduced.
(4). In the embodiment, the block address is allocated to the above-described memory blocks so as to perform the selection operation, so that cutting out, or electrically separating the defective memory block from the main memory circuit can be electrically performed by employing the above-described block address. The specific manufacturing step such as the step for irradiating the laser rays and also wiring can be omitted.
(5). The probing test can be omitted by performing the function test while designating the respective memory blocks from the control circuit. Accordingly, the higher test efficiency can be achieved, and also the occurrence of defects caused by probing the electrodes of the respective circuit blocks, i.e., the break down of the electrodes, can be avoided. As a consequence, the product yield of the semiconductor integrated circuit device can be improved.
(6). The defect releiving process can be performed at a higher efficiency by outputting the address signal (block address) corresponding to the defective memory block.

As the detailed arrangement of a single memory block, not only the above-described shared sense amplifier system, but also the sense amplifier arrangement located at the end portion of the data line and other various types of system may be utilized. The memory block may be constructed of the above-described dynamic type RAM, but also a static type RAM. Moreover, it may be possible to simultaneously employ a dynamic type RAM, static type RAM and mask ROM.

As the circuit blocks having the specific circuit function, not only the above-described memory blocks, but also a peripheral circuit constituting a micro-computer system may be utilized. In this case, the circuit block containing the defect can be essentially separated from the system by allocating the above-described block address.

It should be noted that the present invention can be widely applied to a VLSI which is constructed of a wafer-scale substrate.

The effects achieved by the above-mentioned embodiment will now be briefly described. That is to say, the system can be built up on the wafer by comprising a plurality of circuit blocks having the specific circuit functions, and allocating the block address to designate the respective circuit blocks. Therefore, it is possible to perform the function test for the respective circuit blocks by designating the block address. Also by employing the above-defined block address, the defective, or fault circuit block can be practically cut out from the main circuit block. As a consequence, the conventional steps for cutting off the wiring line by irradiating the laser beams time to time, and for wiring the effective circuit blocks can be omitted.

## Claims

1. A wafer-scale semiconductor integrated circuit device (WSI) comprising:
a wafer-scale semiconductor substrate having a main surface including a central portion, wherein the main surface of the wafer-scale semiconductor substrate has substantially a circular shape;
a plurality of memory blocks (M0 to M29) being formed on the main surface of the wafer-scale semiconductor substrate and each having a substantially the same area, wherein the memory blocks (M0 to M29) are provided at the central portion of the main surface;
a plurality of preliminary memory circuits (RM) formed at the peripheral portion of the main surface of the wafer-scale semiconductor substrate so as to surround the plurality of memory blocks (M0 to M29), wherein each preliminary memory circuit (RM) occupies a smaller area than that of the memory block (M0 to M29); and
a control circuit arranged to detect when a defect is present in at least a part of any one of said memory blocks, to select one or more of the preliminary memory blocks (RM), the memory capacity of the selected preliminary memory block(s) being the same as said at least a part of said any one of said memory blocks, to inhibit the storing of data in said at least a part of said any one of said memory blocks, and to store said data in the selected preliminary memory block(s) rather than said at least a part of said any one of said memory blocks, thereby to relieve said defect.

2. A wafer-scale semiconductor integrated circuit device according to claim 1, wherein each of the preliminary memory circuits (RM) occupies substantially a rectangular area on the main surface, and wherein each of the memory blocks (M0 to M29) occupies substantially a rectangular area on the main surface.

3. A wafer-scale semiconductor integrated circuit device according to 1 or claim 2, wherein each preliminary memory circuit (RM) has ¼ the memory capacity of the memory block.

4. A wafer-scale semiconductor integrated circuit device according to any one of the preceding claims, wherein each preliminary memory circuit (RM) includes a memory array.

5. A wafer-scale semiconductor integrated circuit device according to any one of the preceding claims, wherein each of the memory blocks (M0 to M29) includes a memory array and a decoder circuit.

6. A wafer-scale semiconductor integrated circuit device according to any one of the preceding claims, wherein each preliminary memory circuit (RM) includes a memory array and a decoder circuit.

7. A wafer-scale semiconductor integrated circuit device according to claim 1, wherein both the preliminary memory circuits (RM) and the memory blocks are random access memories.

8. A wafer-scale semiconductor integrated circuit device according to any one of the preceding claims, wherein block addresses are allocated to the respective memory blocks (M0 to M29) and the control circuit is arranged to output the block address corresponding to the memory block having (M0 to M29) the defect.

9. A wafer-scale semiconductor integrated circuit device according to any one of the preceding claims, wherein block addresses are allocated so as to permit the selection operation to be performed by employing the block addresses.

## Patentansprüche

1. Wafer-große integrierte Halbleiterschaltungsvorrichtung (WSI), aufweisend:
ein Wafer-großes Halbleitersubstrat mit einer einen Mittelbereich aufweisenden, im wesentlichen runden Hauptoberfläche,
mehrere Speicherblöcke (M0 bis M29), die auf der Hauptoberfläche des Wafer-großen Halbleitersubstrats ausgebildet sind, jeweils im wesentlichen die gleiche Fläche aufweisen und im Mittelbereich der Hauptoberfläche vorgesehen sind,
mehrere Vorspeicherschaltungen (RM), die in einem peripheren Bereich der Hauptoberfläche des Wafer-großen Halbleitersubstrats um die genannten mehreren Speicherblöcke (M0 bis M29) herum ausgebildet sind und jeweils eine kleinere Fläche als ein Speicherblock (M0 bis M29) belegen, und
eine Steuerschaltung, die eingerichtet ist, das Vorhandensein eines Defekts in mindestens einem Teil irgendeines Speicherblocks zu erfassen, einen oder mehrere Vorspeicherblöcke (RM) auszuwählen, dessen oder deren Speicherkapazität genau so groß wie der genannte mindestens eine Teil des genannten irgendeinen Speicherblocks ist, das Speichern von Daten in dem genannten mindestens einen Teil des genannten irgendeinen Speicherblocks zu verhindern und die genannten Daten in den ausgewählten Vorspeicherblock bzw. die ausgewählten Vorspeicherblöcke anstelle des mindestens einen Teils des genannten irgendeinen Speicherblocks zu speichern, um dem Defekt abzuhelfen.

2. Vorrichtung nach Anspruch 1, wobei jede der Vorspeicherschaltungen (RM) im wesentlichen eine rechteckige Fläche auf der Hauptoberfläche einnimmt und jeder der Speicherblöcke (M0 bis M29) im wesentlichen eine rechteckige Fläche auf der Hauptoberfläche einnimmt.

3. Vorrichtung nach Anspruch 1 oder 2, wobei jede Vorspeicherschaltung (RM) ein Viertel der Speicherkapazität eines Speicherblocks aufweist.

4. Vorrichtung nach einem der vorhergehenden Ansprüche, wobei jede Vorspeicherschaltung (RM) ein Speicherfeld beinhaltet.

5. Vorrichtung nach einem der vorhergehenden Ansprüche, wobei jeder Speicherblock (M0 bis M29) ein Speicherfeld und eine Decoderschaltung beinhaltet.

6. Vorrichtung nach einem der vorhergehenden Ansprüche, wobei jede Vorspeicherschaltung (RM) ein Speicherfeld und eine Decoderschaltung beinhaltet.

7. Vorrichtung nach Anspruch 1, wobei sowohl die Vorspeicherschaltungen (RM) als auch die Speicherblöcke Speicher mit wahlfreiem Zugriff sind.

8. Vorrichtung nach einem der vorhergehenden Ansprüche, wobei den jeweiligen Speicherblöcken (M0 bis M29) Blockadressen zugeordnet sind und die Steuerschaltung eingerichtet ist, die dem Speicherblock (M0 bis M29) mit dem Defekt entsprechende Blockadresse auszugeben.

9. Vorrichtung nach einem der vorhergehenden Ansprüche, wobei Blockadressen so zugeordnet sind, daß die Auswahlfunktion unter Verwendung der Blockadressen ausgeführt werden kann.

## Revendications

1. Dispositif de circuit intégré à semi-conducteurs à l'échelle d'une tranche (WSI), comprenant :
un substrat semi-conducteur à l'échelle d'une tranche comportant une surface principale comprenant une partie centrale, la surface principale du substrat semi-conducteur à l'échelle d'une tranche ayant une forme sensiblement circulaire ;
une pluralité de blocs de mémoire (M0 à M29) formés sur la surface principale du substrat semi-conducteur à l'échelle d'une tranche et ayant chacun sensiblement la même surface, les blocs de mémoire (M0 à M29) étant disposés sur la partie centrale de la surface principale ;
une pluralité de circuits de mémoire préliminaires (RM) formés à la partie périphérique de la surface principale du substrat semi-conducteur à l'échelle d'une tranche de façon à entourer la pluralité de blocs de mémoire (M0 à M29), chaque circuit de mémoire préliminaire (RM) occupant une surface inférieure à celle du bloc de mémoire (M0 à M29) ; et
un circuit de commande configuré de façon à détecter le moment où un défaut est présent dans au moins une partie de l'un quelconque desdits blocs de mémoire, afin de sélectionner un ou plusieurs des blocs de mémoire préliminaires (RM), la capacité de mémoire du ou des blocs de mémoire préliminaires sélectionnés étant la même que celle de ladite partie au moins dudit bloc quelconque parmi lesdits blocs de mémoire, de façon à inhiber la mémorisation de données dans ladite partie au moins dudit bloc quelconque parmi lesdits blocs de mémoire, et à mémoriser lesdites données dans le ou les blocs de mémoire préliminaires sélectionnés au lieu que ce soit dans ladite partie au moins dudit bloc quelconque parmi lesdits blocs de mémoire, de façon à éliminer par conséquent ledit défaut.

2. Dispositif de circuit intégré à semi-conducteurs à l'échelle d'une tranche selon la revendication 1, dans lequel chacun des circuits de mémoire préliminaires (RM) occupe sensiblement une surface rectangulaire sur la surface principale, et dans lequel chacun des blocs de mémoire (M0 à M29) occupe sensiblement une surface rectangulaire sur la surface principale.

3. Dispositif de circuit intégré à semi-conducteurs à l'échelle d'une tranche selon la revendication 1 ou la revendication 2, dans lequel chaque circuit de mémoire préliminaire (RM) a une capacité de mémoire égale au quart de celle du bloc de mémoire.

4. Dispositif de circuit intégré à semi-conducteurs à l'échelle d'une tranche selon l'une quelconque des revendications précédentes, dans lequel chaque circuit de mémoire préliminaire (RM) comprend un réseau de mémoire.

5. Dispositif de circuit intégré à semi-conducteurs à l'échelle d'une tranche selon l'une quelconque des revendications précédentes, dans lequel chacun des blocs de mémoire (M0 à M29) comprend un réseau de mémoire et un circuit décodeur.

6. Dispositif de circuit intégré à semi-conducteurs à l'échelle d'une tranche selon l'une quelconque des revendications précédentes, dans lequel chaque circuit de mémoire préliminaire (RM) comprend un réseau de mémoire et un circuit décodeur.

7. Dispositif de circuit intégré à semi-conducteurs à l'échelle d'une tranche selon la revendication 1, dans lequel les circuits de mémoire préliminaires (RM) et les blocs de mémoire sont tous deux des mémoires vives.

8. Dispositif de circuit intégré à semi-conducteurs à l'échelle d'une tranche selon l'une quelconque des revendications précédentes, dans lequel des adresses de bloc sont attribuées aux blocs de mémoire respectifs (M0 à M29) et le circuit de commande est configuré de façon à délivrer en sortie l'adresse de bloc correspondant au bloc de mémoire (M0 à M29) comportant le défaut.

9. Dispositif de circuit intégré à semi-conducteurs à l'échelle d'une tranche selon l'une quelconque des revendications précédentes, dans lequel les adresses de bloc sont attribuées de façon à permettre d'effectuer l'opération de sélection en employant les adresses de bloc.
